# FASCICULE DE BREVET EUROPEEN

(11) **EP 3 048 367 B1**
(45) Date de publication et mention de la délivrance du brevet: **01.05.2019**
(21) Numéro de dépôt: 16151958.2
(22) Date de dépôt: 19.01.2016
(51) Int. Cl.: F23C 3/00, F23C 6/02

(54) **MODULE DE COMBUSTION PRESENTANT UNE TEMPERATURE SENSIBLEMENT UNIFORME**
VERBRENNUNGSMODUL, DAS EINE DEUTLICH EINHEITLICHE TEMPERATUR AUFWEIST
COMBUSTION MODULE HAVING A SUBSTANTIALLY UNIFORM TEMPERATURE

(30) Priorité: 20.01.2015 FR 1550450
(43) Date de publication de la demande: 27.07.2016
(73) Titulaire: Commissariat à l'Énergie Atomique et aux Énergies Alternatives, 75015 Paris (FR)
(72) Inventeur: OLLIER, Emmanuel, 38000 GRENOBLE (FR)
(74) Mandataire: Brevalex

(56) Documents cités:
- WO-A1-88/02061
- WO-A1-2014/048992
- US-A- 4 473 044
- US-A1- 2007 131 183
- US-A1- 2014 047 822

## Description

### DOMAINE TECHNIQUE ET ART ANTÉRIEUR

La présente invention se rapporte à un module de combustion présentant une température sensiblement uniforme, notamment dans une direction transversale à la direction des chambres de combustion et à un système solaire hybride comportant au moins un tel module de combustion.

Il existe des dispositifs de production d'électricité comportant un module de combustion et un module thermoélectrique, la face chaude du module thermoélectrique étant en contact avec l'une des faces du module de combustion. En brûlant un ou des gaz dans le module de combustion, la face du module thermoélectrique en contact avec le module de combustion est échauffée, un gradient de température apparaît dans le module thermoélectrique, il y a alors production d'électricité.

Un exemple de tel dispositif est décrit dans le document US 7 862 331.

Le module de combustion comporte une chambre alimentée en gaz par au moins un tuyau d'alimentation, les gaz de combustion sont évacués par au moins un conduit d'évacuation.

Le matériau du module présente une très bonne conductivité thermique puisque l'on souhaite utiliser la chaleur produite dans le module à l'extérieur du module.

Le document WO2014/048992 décrit un dispositif solaire hybride de production d'électricité comportant un module dont une première face soumise au rayonnement solaire, une deuxième face en contact avec un générateur thermoélectrique et par exemple une chambre de combustion entre la première face et la deuxième face. Les chambres de combustion sont de forme tubulaire et sont disposées les unes à côté des autres et parallèlement à la première face soumise au rayonnement solaire et à la deuxième face en contact avec le générateur thermoélectrique.

Or on constate que, lorsque les chambres de combustion sont allumées, le module ne présente pas une température uniforme, notamment dans une direction transversale aux chambres de combustion. Les zones latérales sont sensiblement plus froides que la zone centrale du module. Il en résulte que la face en contact avec le générateur thermoélectrique ne présente pas une température sensiblement homogène sur toute sa surface, ce qui peut être dommageable pour l'efficacité du fonctionnement du générateur thermoélectrique. Le même problème se pose si le générateur thermoélectrique est remplacé par une cellule thermophotovoltaïque convertissant le rayonnement infrarouge émis par le module, ce rayonnement n'est pas uniforme sur toute la surface. Dans les deux cas, la non-uniformité en température génère également des contraintes thermomécaniques qui peuvent être dommageables pour la fiabilité du composant.

### EXPOSÉ DE L'INVENTION

C'est par conséquent un but de la présente invention d'offrir un module de combustion comportant un corps muni de plusieurs chambres de combustion, offrant un échauffement sensiblement uniforme du corps.

Le but énoncé ci-dessus est atteint par un module de combustion comportant un corps dans lequel sont formées plusieurs chambres de combustion s'étendant parallèlement les unes par rapport aux autres entre une première face d'extrémité et une deuxième face d'extrémité du corps, la distance entre les chambres et/ou les dimensions des chambres sont choisies de sorte à obtenir un échauffement sensiblement uniforme du corps, notamment dans une direction transversale aux chambres de combustion.

En d'autres termes, on distribue les chambres de combustion dans le corps et/ou on adapte leurs dimensions de sorte que l'énergie thermique délivrée par chacune des chambres de combustion permette d'obtenir au moins une réduction du gradient de température transversal.

Selon l'invention, on peut réaliser un module dans lequel des chambres de combustion ayant la plus grande section transversale sont situées proches des bords latéraux. On compense ainsi les pertes thermiques au niveau des bords latéraux. Selon l'invention, les chambres de combustion situées dans la zone centrale peuvent être éloignées les uns des autres de sorte à limiter l'échauffement dans la zone centrale du module dans laquelle la chaleur est naturellement confinée.

De manière très avantageuse, un ou des connecteurs isolants thermiques sont prévus au niveau des faces d'extrémité par l'intermédiaire desquels les chambres de combustion sont alimentées et les gaz de combustion sont évacués.

La présente invention a alors pour objet un module de combustion comportant un corps dans lequel sont formées plusieurs chambres de combustion s'étendant parallèlement les unes par rapport aux autres le long d'un direction longitudinale entre une première face d'extrémité et une deuxième face d'extrémité du corps, la distance entre les chambres de combustion et/ou les dimensions des chambres de combustion sont choisies de sorte à réduire un gradient de température transversal aux chambres de combustion.

Dans un exemple de réalisation, le corps comporte deux faces latérales et des premières chambres de combustion situées à proximité des faces latérales et des deuxièmes chambres de combustion disposées entre les premières chambres de combustion, les premières chambres de combustion présentant une section transversale supérieure aux deuxièmes chambres de combustion.

Dans un autre exemple de réalisation, le corps comporte deux faces latérales et des premières chambres de combustion situées à proximité des faces latérales et des deuxièmes chambres de combustion disposées entre les premières chambres de combustion, et une distance séparant deux deuxièmes chambres de combustion étant supérieure à une distance séparant une première chambre de combustion et une deuxième chambre de combustion.

De préférence, les chambres de combustion sont des chambres de combustion catalytiques.

Les surfaces intérieures des chambres de combustion sont avantageusement au moins en partie recouvertes d'au moins un matériau catalyseur, par exemple le platine, apte à provoquer une combustion de un ou plusieurs gaz.

Le module de combustion peut comporter au moins un premier connecteur en contact avec la première face d'extrémité du corps et destiné à être assurer la connexion entre les chambres de combustion et au moins une source d'au moins un gaz et/ou une zone d'évacuation des gaz de combustion, ledit connecteur présentant une conductivité thermique sensiblement plus faible que celle du corps.

Le module peut comporter un deuxième connecteur en contact avec la deuxième face d'extrémité du corps et destiné à assurer la connexion entre les chambres de combustion et au moins une source d'au moins un gaz et/ou une zone d'évacuation des gaz de combustion, ledit connecteur présentant une conductivité thermique sensiblement plus faible que celle du corps.

Le premier connecteur peut être destiné à connecter les chambres de combustion et au moins une source d'au moins un gaz, ledit premier connecteur comportant un orifice d'alimentation destiné à être connecté à la source une source de gaz par un conduit, autant de canaux que de chambre de connexion, lesdits canaux reliant l'orifice d'alimentation et les chambres de combustion.

Chaque canal présente avantageusement une section proche de ou identique à celle de la chambre de combustion à laquelle il est relié.

De préférence, le premier connecteur comporte une chambre de distribution en aval de l'orifice d'alimentation et en amont des canaux.

Dans un exemple de réalisation, le premier connecteur comporte au moins deux orifices d'entrée et autant d'orifices de sortie que de chambres de combustion, un réseau de distribution du gaz entre les orifices d'entrée et les orifices de sortie, et une zone de mélange située en aval des deux orifices d'entrée et en amont du réseau de distribution.

Le premier connecteur peut avantageusement comporter une structure apte à favoriser le mélange des gaz, par exemple une structure poreuse.

Par exemple, le corps est en SiC et le connecteur d'alimentation et le connecteur d'évacuation sont en zircone.

La présente invention a également pour objet un dispositif de combustion comportant au moins un module de combustion selon l'invention, au moins une source et un conduit connecté à l'orifice d'entrée du connecteur d'alimentation et à la source de gaz

La présente invention a également pour objet un système solaire hybride comportant des moyens de concentration du rayonnement solaire, au moins un module de combustion selon l'invention ou un dispositif de combustion selon l'invention, le module ou le dispositif étant disposé de sorte que les rayonnement concentré éclaire une face du corps et des moyens de conversion d'une énergie thermique en électricité sur une face opposée à celle éclairée par le rayonnement solaire concentré, et des moyens de commande de la combustion dans le module de combustion en fonction du rayonnement solaire concentré. Les moyens de concentration du rayonnement solaire comportent par exemple au moins un miroir ou une lentille de Fresnel.

### BRÈVE DESCRIPTION DES DESSINS

La présente invention sera mieux comprise à l'aide de la description qui va suivre et des dessins en annexe, sur lesquels :
- la figure 1 est une vue en perspective en transparence d'un exemple de réalisation d'un module de combustion selon l'invention,
- la figure 2A est une vue en coupe transversale du module de la figure 1 sur laquelle les températures en fonctionnement sont symbolisées par des niveaux de gris,
- la figure 2B est une vue en coupe transversale du module de l'état de la technique sur laquelle les températures en fonctionnement sont symbolisées par des niveaux de gris,
- les figures 3A et 3B sont des vues de dessus et en coupe longitudinale respectivement d'un exemple de réalisation d'un module de combustion selon l'invention comportant un connecteur isolant thermique,
- la figure 3C est une en coupe d'un autre exemple de réalisation d'un module de combustion selon l'invention comportant un connecteur isolant thermique,
   - - la figure 4 est une vue en coupe partielle d'un autre exemple de réalisation d'un module de combustion selon l'invention comportant un connecteur isolant thermique,
- la figure 5 est une vue de dessus d'un autre exemple de réalisation d'un module de combustion selon l'invention comportant un connecteur isolant thermique,
- la figure 6 est une vue de dessus d'un autre exemple de réalisation d'un module de combustion selon l'invention comportant deux connecteurs isolants thermiques,
- la figure 7 est une représentation schématique d'un système solaire hybride comportant un module de combustion selon l'invention.

### EXPOSÉ DÉTAILLÉ DE MODES DE RÉALISATION PARTICULIERS

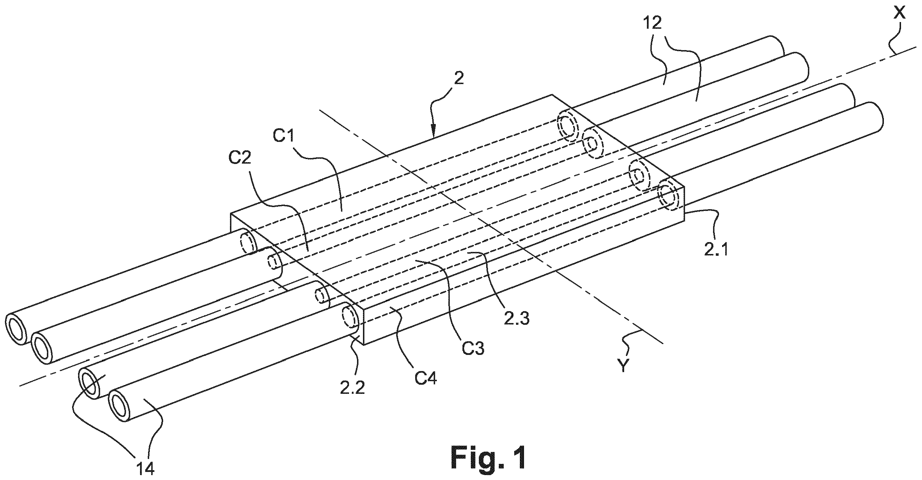

Sur la figure 1, on peut voir un exemple de module de combustion M1 comportant un corps 2 comprenant une pluralité de chambres de combustion C1, C2, C3, C4.

Le corps 2 s'étend le long d'une direction longitudinale X et présente une première face longitudinale 2.1 ou première face d'extrémité 2.1 et une deuxième face longitudinale 2.2 ou deuxième face d'extrémité 2.2. Dans l'exemple représenté, le corps a la forme d'un parallélépipède rectangle. Il comporte en outre une face supérieure 2.3 et une face inférieure (non visible) qui présentent des plus grandes surfaces et deux faces latérales 2.4.

Les chambres de combustion C1, C2, C3, C4 s'étendent parallèlement à une direction X.

Dans l'exemple représenté, chaque chambre C1, C2, C3, C4 se présente sous la forme d'un canal tubulaire dont une première extrémité débouche dans la première face 2.1 et dont une deuxième extrémité débouche dans la deuxième face 2.2.

Une extrémité de chaque chambre C1, C2, C3, C4 est destinée à l'alimentation en un ou plusieurs gaz (combustible et comburant), désignés par la suite "gaz d'alimentation", en vue de la combustion et une autre extrémité de chaque chambre C1, C2, C3, C4 est destinée à l'évacuation des gaz de combustion et des gaz imbrûlés éventuels.

Le module comporte des conduits 12 d'alimentation en gaz des chambres de combustion connectés chacun à l'une des extrémités des chambres de combustion et des conduits 14 d'évacuation des gaz de combustion connectés chacun à une des extrémités des chambres de combustion. Dans l'exemple représenté sur la figure 1, les chambres sont toutes alimentées par leur extrémité située dans la face d'extrémité 2.1 et sont évacuées par leur extrémité située dans la face d'extrémité 2.2.

Dans l'exemple représenté, les chambres C1 et C4 situées les plus à l'extérieur du corps, i.e. les plus proches des faces latérales 2.4 du corps, présentent des sections transversales plus grandes que celles des chambres C2 et C3. Dans l'exemple représenté, les chambres étant à section transversale circulaire, le diamètre D1 des chambres C1 et C4 est supérieur au diamètre D2 des chambres C2 et C3.

La section transversale des conduits 12 et 14 sont adaptées à celle des chambres auxquelles ils sont connectés.

De manière avantageuse, les chambres de combustion sont de type catalytique. Un matériau catalyseur est prévu dans les chambres de combustion pour provoquer la combustion. Ce matériau catalyseur recouvre de préférence la surface intérieure des chambres de combustion. Il en résulte que plus la chambre de combustion a une grande surface intérieure, plus la quantité de catalyseur est importante et donc plus la quantité de chaleur produite par combustion est grande.

Le platine ou le palladium est par exemple mis en oeuvre comme catalyseur de combustion de l'hydrogène. Les catalyseurs peuvent être purs ou associés à des oxydes comme l'oxyde de cérium ou l'alumine.

Ainsi la quantité de chaleur produite dans les chambres C1 et C4 est supérieure à celle produite dans les chambres C2 et C3.

La combustion pourrait aussi être provoquée par l'apport d'énergie extérieure comme un arc électrique, ou dans le cas d'un système solaire hybride, par l'apport de chaleur par concentration solaire. Dans le cas d'une combustion catalytique, un plus grand diamètre de chambre permet avantageusement d'augmenter la chaleur produite de part une plus grande surface de réaction. Une texturation de la surface de réaction peut également être avantageusement prévue. Dans le cas d'une réaction en phase gazeuse, un plus grand diamètre de chambre permet avantageusement d'augmenter la chaleur produite de part un plus grand volume de réaction.

En outre, dans l'exemple représenté et de manière avantageuse, les chambres ne sont pas réparties de manière uniforme dans le corps, i.e. les distances transversales selon la direction Y, séparant les chambres sont différentes. Dans l'exemple représenté, la distance d1 séparant les deux chambres C2 et C3 adjacentes situées dans une zone centrale du corps 2 est plus grande que celle d2 séparant les chambres C1 et C2 et celle d3 séparant les chambre C3 et C4.

Les faces latérales 2.4 sont naturellement des zones de pertes thermiques par radiation, convection et conduction avec l'extérieur. Par ailleurs la zone centrale du corps est moins sujette aux pertes thermiques, par conséquent l'augmentation de la température est plus rapide et plus facile dans la zone centrale qu'au niveau des zones latérales du corps. En mettant en oeuvre des chambres de combustion générant plus de chaleur dans les zones latérales par rapport aux chambres de combustion dans la zone centrale, on compense au moins en partie les pertes thermiques par rapport à la zone centrale. En outre, en éloignant les chambres de combustion C2 et C3 l'une de l'autre, on réduit la quantité de chaleur délivrée dans la zone centrale par rapport à celle délivrée dans les zones latérales. On tend alors à réduire le gradient thermique entre la température dans la zone centrale du corps et la température au niveau des bords latéraux.

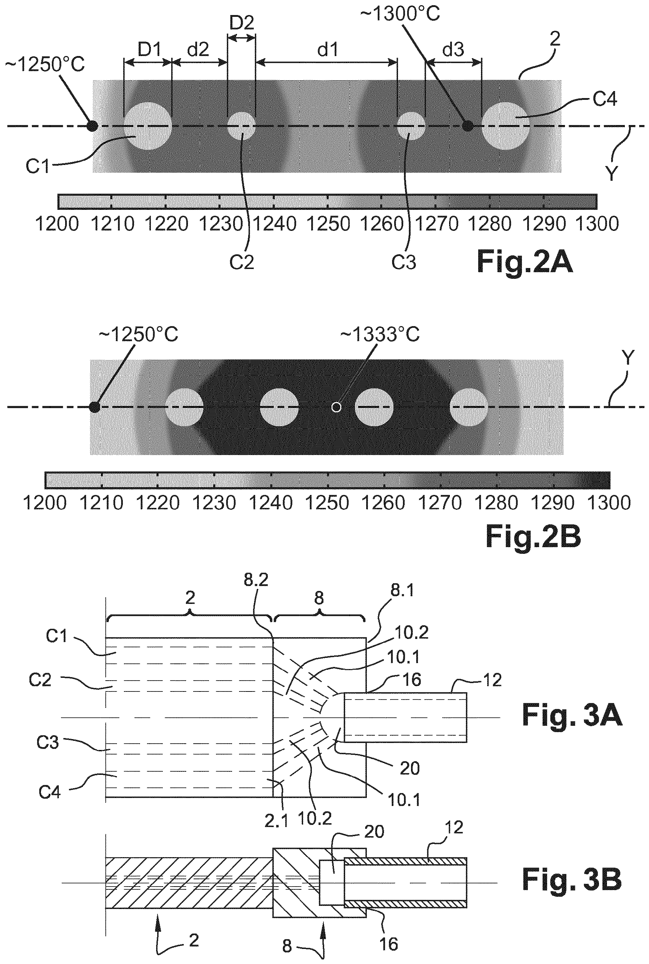

Sur les figures 2A et 2B, on peut voir des sections transversales de corps de combustion selon la figure 1 et selon l'état de la technique respectivement sur lesquelles des cartes de température sont représentées de manière schématique, les niveaux de gris représentant différentes valeurs de température.

Sur la figure 2B, on constate une forte différence de température entre la zone centrale qui est à environ 1333°C et les bords latéraux qui sont à environ 1220°C. Le gradient de température est alors de l'ordre de 113°C

Sur la figure 2A, la température dans le corps est d'environ 1300°C et la température sur les faces latérales est d'environ 1250°C, le gradient de température est alors de l'ordre de 50°C. Grâce au choix des dimensions des chambres et à leur répartition, on obtient une réduction sensible du gradient de température transversale dans le corps.

Les modules considérées pour les figures 2A et 2B présentent les caractéristiques suivantes:
- le corps a une dimension selon la direction X égale à 25 mm, une dimension selon la direction Y égale à 25 mm et une dimension selon une direction perpendiculaire aux directions X et Y égale à 5 mm;
- les chambres de combustion C1 et C4 ont un diamètre de combustion D1 égale à 2,5 mm;
- les chambres de combustion C2 et C3 ont un diamètre de combustion D2 égale à 1,5 mm,
- d2 = d3 = 2,5mm;
- d1 = 7,5mm, et
- une puissance totale injectée de 400W est injectée dans les parois intérieures due à la combustion catalytique sur les parois.

Dans l'exemple représenté, le module a une structure symétrique par rapport à un plan de symétrie contenant l'axe X, ce qui permet très avantageusement de réduire les gradients thermiques transversaux dans le corps.

De manière préférée, le rapport D1/D2 est compris entre 1 et 5. Avantageusement le rapport d1/d2 est compris entre 1 à 5, et de préférence proche de 2.

Avantageusement, on cherche à avoir un gradient de température inférieure à 100°C, de préférence inférieur à 50°C.

Il sera compris qu'un module dans lequel les chambres de combustion sont réparties uniformément mais dans lequel ce sont les dimensions des chambres qui varient pour réduire le gradient transversal et un module dans lequel les chambres de combustion ont toutes les mêmes dimensions mais dont la répartition permet de réduire le gradient de température transversal ne sortent pas du cadre de la présente invention.

Dans l'exemple représenté, les chambres de combustion ont une section circulaire mais des chambres présentant une autre section, par exemple ellipsoïdale ou rectangulaire, ne sort pas du cadre de la présente invention.

En variante, on peut prévoir que des conduits d'alimentation et d'évacuation connectés à des chambres différents soient connectés sur une même face d'extrémité du corps, ce qui présente l'avantage d'uniformiser encore d'avantage la température du corps mais au niveau des extrémités longitudinales du corps.

Par exemple, les chambres de combustion peuvent par exemple être alimentées par un mélange H₂/air. En variante elles peuvent être alimentées par un mélangeH₂/O₂.

En variante encore, les chambres de combustion peuvent être alimentées par un mélange H₂/CH₄/air, la quantité de CH₄ étant faible par rapport à celle de H₂.

En variante encore, les chambres de combustion peuvent être alimentées par un mélange CH₃OH/air. Il est alors préférable de préchauffer le mélange d'entrée, par exemple à au moins 200°C. Ce préchauffage peut avantageusement être obtenu par l'énergie solaire dans le cas d'un système de combustion mis en oeuvre dans un système solaire hybride.

Sur les figures 3A et 3B, on peut voir un exemple de réalisation d'un module de combustion comportant un connecteur 8 monté sur la face d'extrémité 2.1 du corps 2. Le connecteur 8 comporte des canaux 10.1, 10.2 connectés à chacune des chambres de combustion. La section transversale des canaux est identique ou proche de celles des chambres de combustion auxquelles ils sont connectés. Dans l'exemple représenté, les canaux 10.1 ont une section égale à celle des chambres C1 et C4 et la les canaux 10.2 ont une section égale à celle des chambres C2 et C3. Il est à noter que les canaux 10.21, 10.2 s'étendant en biais par rapport à la direction des chambres de combustion, c'est la section des canaux dans le plan de la face d'extrémité 8.2 qui est à considérer.

Le connecteur 8 est en un matériau isolant thermique, i.e. présentant une conductivité thermique réduite par rapport au matériau du corps. Le matériau du connecteur 8 a avantageusement une conductivité thermique inférieure à 50 W/m.K, préférentiellement inférieure à 10W/m.K. Avantageusement le matériau du connecteur d'évacuation a également une conductivité thermique inférieure à 50 W/m.K, préférentiellement inférieure à 10W/m.K. La conductivité thermique du matériau du connecteur 8 est de préférence au moins 5 fois inférieure à celle du corps.

Le connecteur 8 est destiné à connecter les chambres de combustion à une source de gaz d'alimentation.

Le connecteur comporte une face d'extrémité longitudinale 8.1 et une face d'extrémité longitudinale 8.2 en contact avec la face d'extrémité 2.1.

La face d'extrémité 8.1 comporte un seul orifice d'alimentation 16 connecté à un conduit 12 relié à une source de combustible et des canaux 10.1, 10.2 s'étendant entre l'orifice d'alimentation 16 et la face 8.2 dans laquelle ils débouchent.

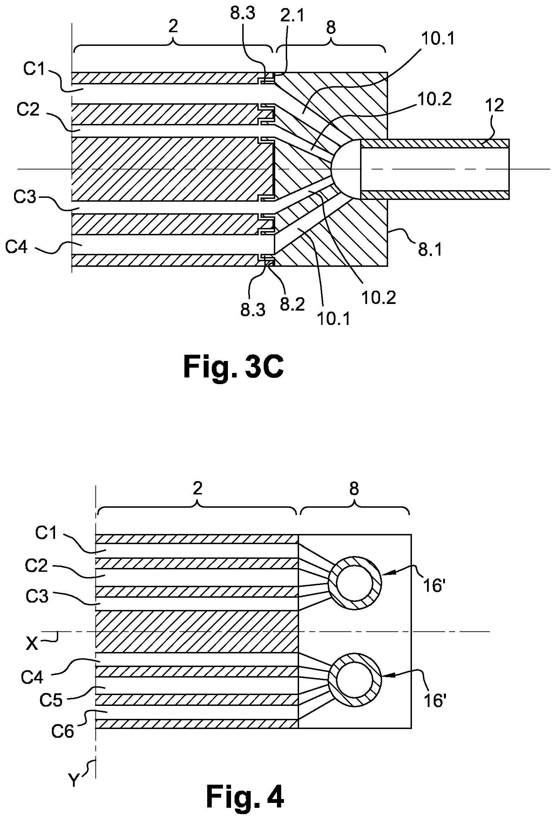

Par exemple comme cela est représenté sur la figure 3C, la face d'extrémité 8.2 peut comporter des saillies annulaires 8.3 entourant les extrémités des canaux 10 débouchant dans la face 6.2, les saillies annulaires 6.3 s'emboîtant dans la première face d'extrémité du corps.

Dans cet exemple de réalisation, un mélange de gaz, par exemple H₂ et O₂ sont prémélangés avant de circuler dans le connecteur 6 et d'alimenter les chambres de combustion.

De manière avantageuse et comme cela est représenté, une chambre 20 est ménagée en aval de l'orifice d'alimentation 16 et en amont de l'entrée des canaux, formant une chambre de distribution. De manière préférée, la chambre de distribution 20 contient une structure favorisant les mélanges, telle qu'une structure poreuse ou une structure discontinue.

Le connecteur 8 en matériau isolant thermique permet de réduire les pertes thermiques vers l'extérieur.

En outre, en n'utilisant qu'un conduit d'alimentation, les pertes thermiques sont encore réduites.

En outre, le connecteur 8 impose un gradient thermique entre le corps 2 et le ou les conduits d'alimentation, ce gradient est suffisant pour que la température dans le ou les conduits d'alimentation soit inférieure à 600°C, température à laquelle survient généralement une auto-inflammation dans des conditions stoechiométriques. La mise en oeuvre d'un connecteur 6 isolant thermique permet également d'utiliser des tubes en acier.

Sur la figure 4, on peut voir une variante de réalisation du module des figures 3A et 3B dans lequel le connecteur comporte deux orifices d'alimentation et deux groupes de canaux chacun relié à un orifice d'alimentation. En outre, les orifices d'alimentation 16' sont perpendiculaires au plan contenant les chambres de combustion non sensiblement dans le même plan. Dans cet exemple, le module comporte six chambres de combustion C1 àC6. Dans cet exemple, les chambres C1 et C6 ont la plus grande section, les chambres C3 et C4 ont la plus petite section et les chambres C2 et C5 ont des sections intermédiaires.

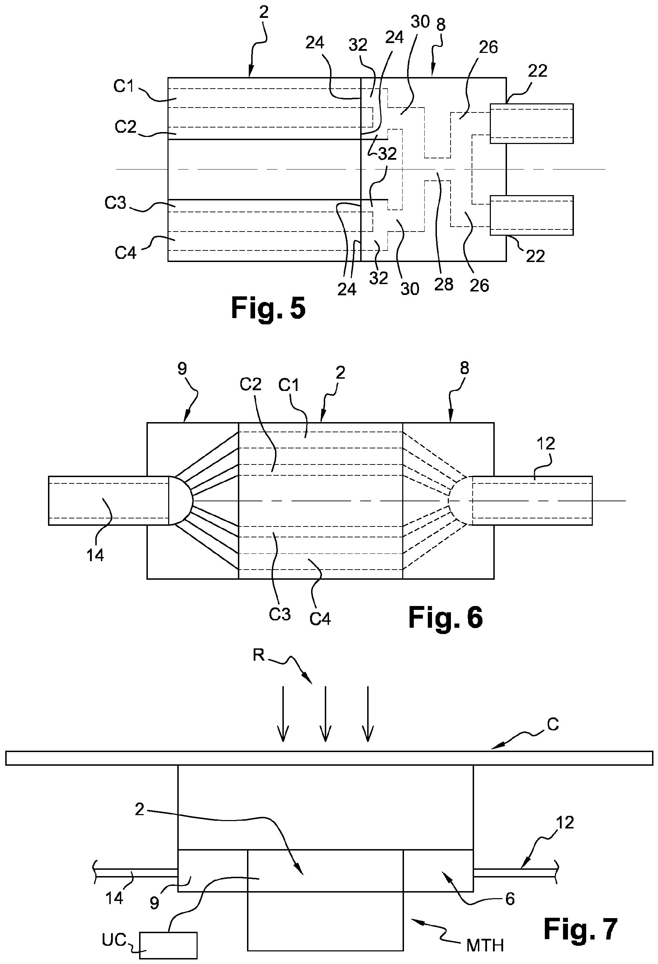

Sur la figure 5, on peut voir un autre exemple de module dans lequel le connecteur d'alimentation 8 comporte deux orifices d'entrée 22 et, quatre orifices de sortie 24 reliées aux chambres de combustion et un réseau de canaux et sous-canaux pour relier les deux orifices d'entrée 22 aux quatre orifices de sortie 24.

Le réseau comporte deux premiers canaux 26 connectés chacun à un orifice d'entrée 22, une chambre de mélange 28 dans laquelle les deux canaux 26 débouchent, deux deuxièmes canaux 30 partant de la chambre de mélange 28 qui se divisent chacun en une paire de sous-canaux 32 débouchant dans deux orifices de sortie 24.

De manière avantageuse, chaque orifice d'entrée est connecté à une source de gaz différente, par exemple l'un est connecté à une source d'oxygène ou d'air et l'autre à une source de H₂. Les deux gaz sont mélangés dans la chambre de mélange 28 avant d'être distribués vers les quatre chambre de combustion. Ce connecteur évite de devoir procéder à un prémélange des gaz avant l'injection dans le connecteur.

De manière très avantageuse, la chambre de mélange peut comporter des moyens pour favoriser le mélange, par exemple elle peut être remplie en tout ou partie par une structure poreuse, par exemple un empilement de bille ou un matériau poreux. La structure peut être macroporeuse ou alors microporeuse.

Le module de combustion peut également comporter un connecteur d'évacuation 9 isolant thermique tel que représenté sur la figure 6, ce qui a pour effet de réduire les pertes thermiques. Avantageusement le matériau du connecteur d'évacuation 9 a également une conductivité thermique inférieure à 50 W/m.K, préférentiellement inférieure à 10W/m.K.

Le connecteur d'évacuation peut avoir une structure symétrique de celle du connecteur d'alimentation.

Dans le cas du connecteur d'alimentation de la figure 5, la mise en oeuvre de deux orifices de sortie et d'une chambre de mélange n'apporte pas d'avantage du côté de l'évacuation. De préférence le connecteur d'évacuation peut avoir une structure proche de ou identique à celle du connecteur des figures 3A et 3B.

En variante, on peut prévoir que le ou les connecteurs assurent à la fois l'alimentation de certaines chambres et l'évacuation de certaines chambres.

L'exemple d'assemblage entre le connecteur et le corps représenté sur la figure 3C s'applique à tous les exemples de connecteur.

Dans le cas d'un module dont le corps présente une dimension selon X égale à 25 mm, une dimension selon Y égale à 25 mm et une dimension selon Z égale à 5 mm, le connecteur d'alimentation et éventuellement le connecteur d'évacuation ont une dimension selon X de 10 mm par exemple.

Le ou les connecteurs peuvent être en zircone, en alumine ou en tout autre matériau isolant thermique tel que la mullite. Le corps du module peut être en SiC, en acier, en aluminium, en cordiérite...Les conduits d'alimentation et ou d'évacuation peuvent être en acier haute température, en alliage Nickel-Cobalt.

Le module en particulier le corps est de préférence réalisé par usinage ainsi que les chambres de combustion

Dans le cas où les canaux dans le ou les connecteurs seraient de forme complexe, le ou les connecteurs peuvent être réalisés par une technologie de moulage par injection de poudre céramique, pour mouler par exemple la zircone, la mullite l'oxyde d'aluminium, le nitrure de silice.

Lors d'une étape suivante, le catalyseur de combustion peut être déposé sur la surface intérieure des chambres de combustion par imprégnation liquide ou par dépôt chimique en phase vapeur.

Lors d'une étape suivante, le corps et les connecteurs sont solidarisés par exemple par brasage ou par soudage.

Lors d'une étape suivante, les tubes d'alimentation et d'évacuation sont solidarisés aux connecteurs, par exemple par soudage ou par brasage.

On peut envisager de solidariser les tubes sur les connecteurs, avant de solidariser les connecteurs au corps.

Ce module de combustion peut être avantageusement mis en oeuvre pour réaliser un système solaire hybride dans lequel la face supérieure est soumise au rayonnement solaire et la face inférieure est en contact avec des modules thermoélectriques, la chaleur produite par la chambre de combustion permettant de compenser les variations d'ensoleillement et d'avoir un fonctionnement sensiblement continu et constant des modules thermoélectriques. La conversion thermique / électrique peut en variante être assurée par une cellule thermophotovoltaïque convertissant le rayonnement infrarouge émis en électricité.

Sur la figure 7, on peut voir une représentation schématique d'un exemple d'un système solaire comportant un module de combustion selon l'invention. Le rayonnement solaire est schématisé par les flèches R.

Le système solaire comporte des moyens de concentration 18 du rayonnement solaire, un module de combustion M1 disposé à l'opposé des moyens de concentration 32 par rapport au soleil de sorte que la face supérieure du corps soit illuminée par le rayonnement solaire concentré et des modules thermoélectriques MTH dont la face chaude est en contact thermique avec la face inférieure du corps du module. Les modules thermoélectriques peuvent être remplacés par des cellules thermophotovoltaïques placées en face de la surface chaude et qui transforment l'émission infrarouge en électricité.

Le système comporte des moyens de commande UC de la combustion de la chambre en fonctionnement du rayonnement solaire concentré de sorte à maintenir une température sensiblement constante sur la face inférieure du corps du module de combustion.

De préférence, la surface supérieure du module destinée à recevoir le flux solaire concentré, et en particulier la surface supérieure du corps est fonctionnalisée avec un absorbeur solaire haute température pour permettre l'échauffement par absorption du rayonnement solaire. Par exemple il peut s'agir d'un absorbeur interférentiel déposé sur la surface supérieure, tel que le TiAlN/AlN/SiO₂ ou un matériau réfractaire nanostructuré tel que le molybdène, le tantale ou le tungstène.

De préférence, la surface inférieure du module, en particulier la surface inférieure du corps, est fonctionnalisée avec un émetteur sélectif tel qu'un empilement de W/Al₂O₃ ou de Si/SiO₂ ou tel qu'un matériau réfractaire nanostructuré tel que le molybdène, le tantale ou le tungstène.

Les surfaces latérales du module, en particulier celles du corps peuvent avantageusement être fonctionnalisé au moyen d'un matériau à basse émissivité tel qu'un matériau réfractaire.

Les moyens de concentration du rayonnement sont par exemple un miroir ou une lentille de Fresnel.

Les modules thermoélectriques peuvent par exemple être remplacés par tout dispositif apte à convertir la chaleur en électricité ou une autre forme d'énergie. Comme cela a été mentionné ci-dessus, les modules thermoélectriques peuvent être remplacés par des cellules thermophotovoltaïques placées en face de la surface chaude et qui convertissent l'émission infrarouge en électricité, par exemple des cellules à base de GaSb.

Le fonctionnement du système solaire va maintenant être décrit.

Lorsque le rayonnement solaire est suffisant il chauffe le corps du module de combustion en frappant sa face supérieure après avoir été concentré.

La chaleur est transmise par conduction à travers le corps jusqu'à la face inférieure grâce au matériau du corps entre les chambres de combustion, un gradient thermique apparaît alors dans les modules thermoélectriques et de l'électricité est produite. Dans le cas de cellules photovoltaïques remplaçant le module thermoélectrique, le rayonnement infrarouge émis par la surface chaude est absorbé et converti en électricité dans la cellule thermophotovoltaïque.

Si le rayonnement est insuffisant, par exemple en cas de passage nuageux ou en période de nuit, des gaz sont brûlés dans les chambres de combustion, une chaleur est produite, qui complète celle produite par le rayonnement solaire ou pallie son absence. Un gradient thermique apparaît alors dans les modules thermoélectriques et de l'électricité est produite. Dans le cas de cellules photovoltaïques remplaçant le module thermoélectrique, le rayonnement infrarouge émis par la surface chaude est absorbé et converti en électricité dans la cellule thermophotovoltaïque.

Le module de combustion selon l'invention est particulièrement adapté à la conversion d'énergie thermique en énergie électrique au moyen de modules thermoélectriques puisqu' il présente notamment une température plus uniforme de la surface inférieure en contact avec les modules. Ceci s'applique également dans le cas où la conversion se fait par des cellules thermophotovoltaïques.

En outre en mettant en oeuvre un ou des connecteurs isolants thermiques, les pertes thermiques vers l'extérieur sont réduite, la quantité de chaleur transmise à la face inférieure du module est donc augmentée.

## Revendications

1. Système solaire hybride comportant des moyens de concentration (C) du rayonnement solaire, au moins un module de combustion (MC) comportant un corps (2) dans lequel sont formées plusieurs chambres de combustion (C1, C2, C3, C4) s'étendant parallèlement les unes par rapport aux autres le long d'une direction longitudinale (X) entre une première face d'extrémité (2.1) et une deuxième face d'extrémité (2.2) du corps (2), le module étant disposé de sorte que le rayonnement concentré éclaire une face du corps, ledit système comportant également des moyens de conversion (MTH) d'une énergie thermique en électricité sur une face opposée à celle éclairée par le rayonnement solaire concentré, et des moyens de commande (UC) de la combustion dans le module de combustion en fonction du rayonnement solaire concentré,
**caractérisé en ce que** le corps (2) comporte deux faces latérales et des premières chambres de combustion (C1, C4) situées à proximité des faces latérales et des deuxièmes chambres de combustion (C2, C3) disposées entre les premières chambres de combustion (C1, C4), les premières chambres de combustion (C1, C4) présentant une section transversale supérieure aux deuxièmes chambres de combustion (C2, C3) et/ou **en ce que** le corps (2) comporte deux faces latérales et des premières chambres de combustion (C1, C4) situées à proximité des faces latérales et des deuxièmes chambres de combustion (C2, C3) disposées entre les premières chambres de combustion (C1, C4), et dans lequel une distance séparant deux deuxièmes chambres de combustion (C2, C3) est supérieure à une distance séparant une première chambre de combustion (C1, C4) et une deuxième chambre de combustion (C2, C3).

2. Système solaire hybride selon la revendication 1, dans lequel les chambres de combustion (C1, C2, C3, C4) sont des chambres de combustion catalytiques, les surfaces intérieures des chambres de combustion (C1, C2, C3, C4) étant avantageusement au moins en partie recouverte d'au moins un matériau catalyseur, par exemple le platine, apte à provoquer une combustion de un ou plusieurs gaz.

3. Système solaire hybride selon la revendication 1 ou 2, comportant au moins un premier connecteur (8) en contact avec la première face d'extrémité (2.1) du corps (2) et destiné à être assurer la connexion entre les chambres de combustion (C1, C2, C3, C4) et au moins une source d'au moins un gaz et/ou une zone d'évacuation des gaz de combustion, ledit connecteur (8) présentant une conductivité thermique sensiblement plus faible que celle du corps (2).

4. Système solaire hybride selon la revendication 3, comportant un deuxième connecteur en contact avec la deuxième face d'extrémité (2.2) du corps (2) et destiné à assurer la connexion entre les chambres de combustion (C1, C2, C3, C4) et au moins une source d'au moins un gaz et/ou une zone d'évacuation des gaz de combustion, ledit connecteur présentant une conductivité thermique sensiblement plus faible que celle du corps (2).

5. Système solaire hybride selon la revendication 3 ou 4, dans lequel le premier connecteur (8) est destiné à connecter les chambres de combustion (C1, C2, C3, C4) et au moins une source d'au moins un gaz, ledit premier connecteur (8) comportant un orifice d'alimentation destiné à être connecté à la source une source de gaz par un conduit, autant de canaux (10) que de chambre de connexion, lesdits canaux reliant l'orifice d'alimentation et les chambres de combustion (C1, C2, C3, C4).

6. Système solaire hybride selon la revendication 5, dans lequel chaque canal (10) présente une section proche de ou identique à celle de la chambre de combustion (C1, C2, C3, C4) à laquelle il est relié.

7. Système solaire hybride selon la revendication 5 ou 6, dans lequel le premier connecteur (8) comporte une chambre de distribution en aval de l'orifice d'alimentation et en amont des canaux (10).

8. Système solaire hybride selon l'une des revendications 3 à 6, dans lequel le premier connecteur (8) comporte au moins deux orifices d'entrée et autant d'orifices de sortie que de chambres de combustion (C1, C2, C3, C4), un réseau de distribution du gaz entre les orifices d'entrée et les orifices de sortie, et une zone de mélange située en aval des deux orifices d'entrée et en amont du réseau de distribution.

9. Système solaire hybride selon la revendication 7 ou 8, dans lequel le premier connecteur (8) comporte une structure apte à favoriser le mélange des gaz, par exemple une structure poreuse.

10. Système solaire hybride selon l'une des revendications 1 à 9, dans lequel le corps (2) est en SiC et le connecteur d'alimentation (6) et le connecteur d'évacuation (8) sont en zircone.

11. Système solaire hybride selon l'une des revendications 1 à 10, comportant au moins une source et un conduit (12) connecté à l'orifice d'entrée du connecteur d'alimentation (8) et à la source de gaz

12. Système solaire hybride selon l'une des revendications 1 à 11, dans lequel les moyens de concentration du rayonnement solaire comportent au moins un miroir ou une lentille de Fresnel.

## Patentansprüche

1. Hybrides Solarsystem, umfassend Konzentrationsmittel (C) für Sonnenstrahlung, wenigstens ein Verbrennungsmodul (MC), welches einen Körper (2) umfasst, in welchem mehrere Brennkammern (C1, C2, C3, C4) gebildet sind, welche sich parallel zueinander entlang einer longitudinalen Richtung (X) zwischen einer ersten Endfläche (2.1) und einer zweiten Endfläche (2.2) des Körpers erstrecken, wobei das Modul derart angeordnet ist, dass die konzentrierte Strahlung eine Fläche des Körpers beleuchtet, wobei das System ferner Umwandlungsmittel (MTH) von einer thermischen Energie in Elektrizität an einer Fläche gegenüber derjenigen, welche durch die konzentrierte Sonnenstrahlung beleuchtet wird, und Steuerungsmittel (UC) für die Verbrennung in dem Verbrennungsmodul als Funktion der konzentrierten Sonnenstrahlung umfasst,
**dadurch gekennzeichnet, dass** der Körper (2) zwei laterale Flächen und erste Brennkammern (C1, C4), welche nahe der lateralen Flächen angeordnet sind, sowie zweite Brennkammern (C2, C3) umfasst, welche zwischen den ersten Brennkammern (C1, C4) angeordnet sind, wobei die ersten Brennkammern (C1, C4) einen größeren transversalen Querschnitt aufweisen als die zweiten Brennkammern (C2, C3) und/oder dadurch, dass der Körper (2) zwei laterale Flächen und erste Brennkammern (C1, C4), welche nahe der lateralen Flächen angeordnet sind, sowie zweite Brennkammern (C2, C3) umfasst, welche zwischen den ersten Brennkammern (C1, C4) angeordnet sind, und wobei eine Distanz, welche zwei zweite Brennkammern (C2, C3) trennt, größer ist als eine Distanz, welche eine erste Brennkammer (C1, C4) und eine zweite Brennkammer (C2, C3) trennt.

2. Hybrides Solarsystem nach Anspruch 1, wobei die Brennkammern (C1, C2, C3, C4) katalytische Brennkammern sind, wobei die inneren Flächen der Brennkammern (C1, C2, C3, C4) vorzugsweise wenigstens teilweise mit einem Katalysatormaterial bedeckt sind, beispielsweise Platin, welches in der Lage ist, eine Verbrennung von einem oder mehreren Gasen hervorzurufen.

3. Hybrides Solarsystem nach Anspruch 1 oder 2, umfassend wenigstens ein erstes Verbindungselement (8) in Kontakt mit der ersten Endfläche (2.1) des Körpers (2) und dazu vorgesehen, die Verbindung zwischen den Brennkammern (C1, C2, C3, C4) und wenigstens einer Quelle von wenigstens einem Gas und/oder einer Auslasszone für die Verbrennungsgase sicherzustellen, wobei das Verbindungselement (8) eine thermische Leitfähigkeit aufweist, welche im Wesentlichen schwächer ist als diejenige des Körpers (2).

4. Hybrides Solarsystem nach Anspruch 3, umfassend ein zweites Verbindungselement in Kontakt mit der zweiten Endfläche (2.2) des Körpers (2) und dazu vorgesehen, die Verbindung zwischen den Brennkammern (C1, C2, C3, C4) und wenigstens einer Quelle von wenigstens einem Gas und/oder einer Auslasszone für die Verbrennungsgase sicherzustellen, wobei das Verbindungselement eine thermische Leitfähigkeit aufweist, welche im Wesentlichen schwächer ist als diejenige des Körpers (2).

5. Hybrides Solarsystem nach Anspruch 3 oder 4, wobei das erste Verbindungselement (8) dazu vorgesehen ist, die Brennkammern (C1, C2, C3, C4) und wenigstens eine Quelle von wenigstens einem Gas zu verbinden, wobei das erste Verbindungselement (8) eine Versorgungsöffnung umfasst, welche dazu vorgesehen ist, mit der Gasquelle durch eine Leitung verbunden zu sein, so viele Kanäle (10) wie Verbindungskammern, wobei die Kanäle die Versorgungsöffnung und die Brennkammern (C1, C2, C3, C4) verbinden.

6. Hybrides Solarsystem nach Anspruch 5, wobei jeder Kanal (10) einen Querschnitt nahe oder identisch zu demjenigen der Brennkammer (C1, C2, C3, C4) aufweist, mit welcher er verbunden ist.

7. Hybrides Solarsystem nach Anspruch 5 oder 6, wobei das erste Verbindungselement (8) eine Verteilungskammer stromabwärts der Versorgungsöffnung und stromaufwärts der Kanäle (10) umfasst.

8. Hybrides Solarsystem nach einem der Ansprüche 3 bis 6, wobei das erste Verbindungselement (8) wenigstens zwei Eintrittsöffnungen und so viele Ausgangsöffnungen wie Brennkammern (C1, C2, C3, C4), ein Verteilungsnetz für Gas zwischen den Eingangsöffnungen und den Ausgangsöffnungen sowie eine Mischungszone umfasst, welche stromabwärts der beiden Eingangsöffnungen und stromaufwärts des Verteilungsnetzes angeordnet ist.

9. Hybrides Solarsystem nach Anspruch 7 oder 8, wobei das erste Verbindungselement (8) eine Struktur umfasst, welche dazu in der Lage ist, das Mischen der Gase zu fördern, beispielsweise eine poröse Struktur.

10. Hybrides Solarsystem nach einem der Ansprüche 1 bis 9, wobei der Körper (2) aus SiC besteht und das Versorgungs-Verbindungselement (6) und das Auslass-Verbindungselement (8) aus Zirkon bestehen.

11. Hybrides Solarsystem nach einem der Ansprüche 1 bis 10, umfassend wenigstens eine Quelle und eine Leitung (12), welche mit der Eingangsöffnung des Versorgungs-Verbindungselements (8) und der Gasquelle verbunden ist.

12. Hybrides Solarsystem nach einem der Ansprüche 1 bis 11, wobei die Konzentrationsmittel für Sonnenstrahlung wenigstens einen Spiegel oder eine Fresnel-Linse umfassen.

## Claims

1. Hybrid solar system comprising means for concentrating (C) solar radiation, at least one Hybrid solar system (MC) comprising a body (2) in which are formed several combustion chambers (C1, C2, C3, C4) extending parallel to each other along a longitudinal direction (X) between a first end face (2.1) and a second end face (2.2) of the body (2), the module being arranged such that concentrated radiation illuminates one face of the body and means for converting (MTH) thermal energy into electricity on a face opposite to that illuminated by the concentrated solar radiation, and means for controlling (UC) combustion in the Hybrid solar system as a function of the concentrated solar radiation,
**characterized in that** the body (2) comprises two lateral faces and first combustion chambers (C1, C4) situated near to the lateral faces and second combustion chambers (C2, C3) arranged between the first combustion chambers (C1, C4), the first combustion chambers (C1, C4) having a transversal section greater than the second combustion chambers (C2, C3) and/or the body (2) comprises two lateral faces and first combustion chambers (C1, C4) situated near to the lateral faces and second combustion chambers (C2, C3) arranged between the first combustion chambers (C1, C4), and in which a distance separating two second combustion chambers (C2, C3) is greater than a distance separating a first combustion chamber (C1, C4) and a second combustion chamber (C2, C3).

2. Hybrid solar system le according to claim 1, in which the combustion chambers (C1, C2, C3, C4) are catalytic combustion chambers, the inner surfaces of the combustion chambers (C1, C2, C3, C4) being advantageously at least in part covered with at least one catalyst material, for example platinum, capable of causing a combustion of one or more gases.

3. Hybrid solar system according to claim 1 or 2, comprising at least one first connector (8) in contact with the first end face (2.1) of the body (2) and intended to assure the connection between the combustion chambers (C1, C2, C3, C4) and at least one source of at least one gas and/or a zone for evacuating combustion gases, said connector (8) having a thermal conductivity substantially lower than that of the body (2).

4. Hybrid solar system according to claim 3, comprising a second connector in contact with the second end face (2.2) of the body (2) and intended to assure the connection between the combustion chambers (C1, C2, C3, C4) and at least one source of at least one gas and/or a zone for evacuating combustion gases, said connector having a thermal conductivity substantially lower than that of the body (2).

5. Hybrid solar system according to claim 3 or 4, in which the first connector (8) is intended to connect the combustion chambers (C1, C2, C3, C4) and at least one source of at least one gas, said first connector (8) comprising a supply orifice intended to be connected to the gas source by a conduit, as many channels (10) as connection chambers, said channels connecting the supply orifice and the combustion chambers (C1, C2, C3, C4).

6. Hybrid solar system according to claim 5, in which each channel (10) has a section similar to or identical to that of the combustion chamber (C1, C2, C3, C4) to which it is connected.

7. Hybrid solar system according to claim 5 or 6, in which the first connector (8) comprises a distribution chamber downstream of the supply orifice and upstream of the channels (10).

8. Hybrid solar system according to one of claims 3 to 6, in which the first connector (8) comprises at least two inlet orifices and as many outlet orifices as combustion chambers (C1, C2, C3, C4), a network for distributing gas between the inlet orifices and the outlet orifices, and a mixing zone situated downstream of the two inlet orifices and upstream of the distribution network.

9. Hybrid solar system according to claim 7 or 8, in which the first connector (8) comprises a structure capable of favoring the mixing of gases, for example a porous structure.

10. Hybrid solar system according to one of claims 1 to 9, in which the body (2) is made of SiC and the supply connector (6) and the evacuation connector (8) are made of zirconium oxide.

11. Hybrid solar system according to one of claims 1 to 10, at least one source and one conduit (12) connected to the inlet orifice of the supply connector (8) and to the gas source.

12. Hybrid solar system according to one of claims 1 to 11, in which the means for concentrating solar radiation comprise at least one Fresnel mirror or lens.
